Europäisches Patentamt

European Patent Office

Office européen des brevets

(19)

(11) Publication number: **0 011 359**

A1

# EUROPEAN PATENT APPLICATION

(21) Application number: **79301981.1**

(22) Date of filing: **24.09.79**

(51) Int. Cl.³: **G 01 R 19 / 00**
**G 01 R 31 / 00, B 60 R 16 / 00**

(30) Priority: **15.11.78 US 960755**

(43) Date of publication of application:
**28.05.80 Bulletin 80 11**

(84) Designated Contracting States:
**AT BE CH DE FR GB IT LU NL SE**

(71) Applicant: **AMERICAN GAGE & MACHINE COMPANY**
**853 Dundee Avenue**
**Elgin, Illinois 60120(US)**

(72) Inventor: **Mills, Frank H.**
**2437 N. Richmond**
**Chicago Illinois 60647(US)**

(74) Representative: **George, Roger David et al,**
**Raworth, Moss & Cook 36 Sydenham Road**
**Croydon Surrey CR0 2EF(GB)**

(54) Method and apparatus for testing electrical circuits.

(57) A method and apparatus for measuring current drain and other circuit parameters, particularly in vehicular electrical systems, the apparatus utilizing a reference current source (80,82) passed through a commonly available system element (8) (the battery ground strap in an automobile) to calibrate a visual indicator (66) in the circuit (14,20,18,38,66) for the particular system being tested. Readings of electrical values can then be made for various parts of the system under test.

EP 0 011 359 A1

./...

Croydon Printing Company Ltd.

FIG.1

- 1 -

Title:  Method and Apparatus for testing electrical
        circuits.

This invention relates generally to a method and apparatus for testing electrical circuits. More particularly, but not exclusively, it relates to a method and apparatus useful for measuring electrical values in vehicular electrical systems.

Vehicular electrical systems utilize a battery and an alternator or generator as sources for the energy required. Ground for such systems is usually provided by connecting the negative battery terminal to a metallic portion of the vehicle through a so-called battery strap. This strap is a conductor of some size as the current flow in the system may be substantial, particularly when the vehicle engine is being started.

Various types of circuits have been provided for testing these circuits. One such circuit with which the applicant is familiar is connected to the system by removing the battery ground strap and connecting a shunt of known resistance in series. A current drain is caused by creating a load and the voltage drop across the shunt is then used to calibrate the test circuit.

Another known method is the "substitution method" in which connections are made to the battery post and a voltmeter. A load such as the starter is energized and the battery terminal voltage read. A dummy variable load within the tester is then connected across the battery. The circuit with the dummy load includes an ammeter. The dummy load is adjusted until the voltmeter reads the value as that previously read when the starter was energized. At this point there is supposed to be at least an approximation of the current drain as indicated on the ammeter when the starter was energized. Other elements of the electrical system are tested in the same way.

A third technique uses a sensor such as a Hall effect device which is responsive to a magnetic field such as would be created by current flow in a conductor. The sensor is brought to the vicinity of the conductor and produces a signal proportional to the current flow therein. These devices and their associated circuitry are relatively costly.

The applicant's knowledge of and experience with the foregoing methods and apparatus has led him to the conclusion that they are unstable or inaccurate or depend much upon the skill of the operator. In addition they are relatively costly to make.

Therefore this invention seeks to provide in an embodiment a novel electrical test apparatus which is reliable and accurate.

This invention also seeks to provide in an embodiment a novel electrical test apparatus which is relatively easy to use because it may be quickly connected to an electrical system to be tested and does not require that any of the elements of the system be themselves disconnected.

This invention further seeks to provide an embodiment which utilizes standard electrical components, including readily available solid state components, and which therefore is relatively inexpensive to manufacture, and in addition, may be constructed as an easily transported instrument.

According to a first aspect of the invention there is provided a method of testing electrical systems having a number of different circuits, each with its own load and a conductive element having an unknown resistance common to all through which current in the system flows when any one or more of the loads is energised, comprising the step of connecting a current measuring circuit including an indicator to the common conductive element, the step of passing a known current through the common conductive element and at the same time calibrating the indicator to eliminate the effect of different resistances which may exist in the common conductive element, and then energizing any one or more of the loads in the different circuits of the electrical system and measuring the current through the common conductive element caused by the energized load or loads.

According to a further aspect of the invention there is provided apparatus for testing electrical systems having a number of different circuits, each with its own load and a conductor connected between a terminal of a source and common ground whereby when any one or more of the loads is energised current will flow in the conductor comprising a current measuring circuit including an indicator and variable gain amplifying means having two inputs and having its output connected to said indicator, means for connecting the inputs of said amplifying means across the ground conductor, means for drawing a known current through the ground conductor and

means for selectivly connecting said last mentioned means to said current measuring circuit.

In embodiments of this apparatus herein referred to as the measuring instrument for testing electrical circuits, particularly vehicular circuits, the apparatus utilizes an existing circuit element as a shunt in order that accurate measurements of current flow in various parts of the system can be made.

An embodiment of the method and apparatus of the invention will now be described by way of example only with reference to the accompanying drawing, in which:

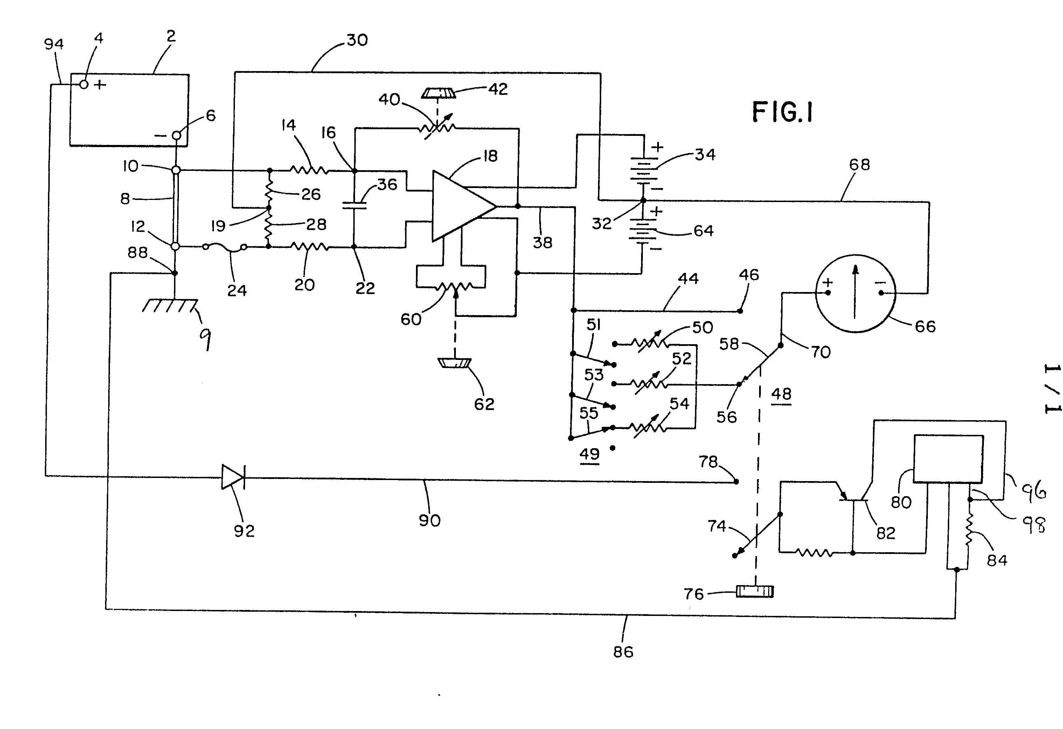

Figure 1 is a schematic diagram of apparatus useful for performing the method.

The apparatus shown in Fig. 1 has a battery 2 such as may be found in a typical vehicular electrical system. The batteries are provided in the conventional manner with a positive terminal 4. A battery ground strap 8 is connected to the negative terminal 6 and is grounded at 9 to some portion of the vehicle frame or body as is conventional. As is well known, so that it need not be shown or described in detail herein, the remainder of the system includes such elements as an alternator or generator, a starter motor, various lights and accessories such as a radio, power window and seat actuators and the like. The arrangement of such systems is that when any of these elements are energised there is a current flow in the battery with of course, a consequent current flow in the battery ground strap 8.

Because of this it is possible to test the various electrical circuits constituting the system by operating

- 5 -

them individually and measuring that current flow.

This embodiment includes a pair of connectors 10 and 12 which at the appropriate time in a test sequence can be connected across the battery ground strap 8 as will be described in greater detail hereinafter. Terminal 10 is connected via an input resistor 14 to the inverting input terminal 16 of an operational amplifier 18. The terminal 12 is connected via another resistor 20 which is used for balance to a second or non-inverting input terminal 22 of the amplifier 18. As may be seen, connected in series between the terminal 12 and resistor 20 is a fuse 24 for protection purposes. Connected across the terminal 10 and junction 19 are a pair of resistors 26 and 28, the junction of which is connected via a conductor 30 to the negative side 32 of a DC source 34 which may take the form of a battery. The resistors 26 and 28 ensure that the input signals to the amplifier 18 are balanced. In order to eliminate the effect of high frequency transients which may create noise or disturbances in the system a capacitor 36 may likewise be connected across the input terminals 16 and 22.

Connected to the output 38 of the amplifier in a conventional manner is a feedback circuit through an adjustable resistor 40, which resistor may be adjusted by a knob 42 mounted on the cabinet in which the apparatus is housed. Manipulation of the resistor 40 serves to calibrate the apparatus using a procedure to be described hereinafter. This calibration is effected by controlling the gain of the amplifier. The output 38 of the amplifier is connected via a conductor 44 to a calibrated terminal 46. The terminal 46 is actually the stationary contact of a calibrate switch 48. It is also

0011359

- 6 -

connected to a multiple contact switch 49. Connected to stationary contacts of the switch 48 are range adjustable selecting resistors 50, 52, and 54. The switch 49 includes independently movable contacts 51, 53 and 55, any one of which can be connected to one of the resistors 50, 52 or 54 respectively. In one embodiment the resistor 50 could be selected to provide a range of up to 300 amps, 52 a range of up to 50 amps and 54 a range of up to 10 amps. The range selecting resistors have a common connection to a stationary contact 56 in the calibrate switch 48. The calibrate switch includes a movable contact 58 which may close either with contact 56 or 46.

Zero offset of the amplifier 18 is provided in the conventional manner by the provision of an external adjustable resistor 60 manipulated by a control knob 62. The zero offset voltage and operating voltage for the amplifier 18 is provided by the battery 34 and a battery 64 connected as shown.

In order to provide an indication of the current flow in the battery ground strap 8 a microammeter 66 calibrated in amperes is provided which will herein be referred to as the visual indicator or indicator. The negative terminal of the indicator is connected via a conductor 68 to the junction 32 while its positive terminal is connected via a conductor 70 to the movable contact 58 in the calibrate switch 48. The calibrate switch is completed by the provision of another movable contact 74 which is normally open but by operating a pushbutton 76 may close with a fixed contact 78.

An important aspect of the embodiment is the calibration of the apparatus when connected to a system

- 7 -

to be tested in order that the resistance of an important element of the system (in the case of vehicular electrical systems the resistance of the battery ground strap) may be established as a shunt, whereby it becomes possible to then accurately measure the current flow when the various elements of the system are operated.

To this end the embodiment includes the provision of a voltage regulator 80, with a control electrode 98, controlling the transistor 82. The calibration circuit also includes a fixed resistor 84 connected to control electrode 98 and a conductor 86 having at its other end a connector shown symbolically at 88. The voltage regulator 80 may be a commercially available device and its input terminal which is used as an output terminal supplies the signal to the base of the transistor 82 to control its conduction so as to maintain a constant voltage across the resistor 84. The output of transistor 82 is connected via line 96 to control electrode 98 of voltage regulator 80. As may be seen, the fixed contact 78 of the calibrate switch 48 is connected via a conductor 90 and blocking diode 92 to a connector 94 which may be connected to the positive terminal 4 of the battery 2, again as will be described hereinafter. In a preferred embodiment the fixed resistor 84 is selected to have a resistance of one ohm while the output of the regulated voltage supply may be selected to be of 5 volts, whereby a constant repeatable current of 5 amps is caused to flow in the calibrate circuit.

The use of the method of this embodiment is as follows. The terminals or connectors 10 and 12 are connected across a battery ground strap 8 in the case of a vehicle or similar circuit element if some other kind of system is being tested. At the same time, the connectors 88 and 94 are connected to the ground and to the positive terminal of the battery. The selector switch 55 is adjusted to the 10 ampere range and with the calibration control 42 approximately centered, zero the indicator 66 using knob 62. The pushbutton 76 is then actuated to operate the switch 48, closing the contacts 74 and 78 and 58 and 46. When the switch 48 is so operated the regulated output of the transistor 82 will be impressed across the fixed resistor 84 via line 96, causing a fixed current flow through that resistor. As stated in the preferred embodiment, these values may be 5 volts and one ohm, whereby a current flow of 5 amps is caused to flow from the battery 2 and consequently in the strap 8. With the calibrate switch 76 depressed the gain of the amplifier 18 is adjusted by the knob 42 so as to give a full scale deflection of the indicator to the discharge side.

The calibrate pushbutton switch 76 is now released and the indicator 66 will now read accurately the current drawn from the battery 2 when a load in a system to be tested is energised. The effect of the procedure just described is to calibrate the measuring instrument to the resistance of the strap in the system under test, and in so doing fix a current value for full scale deflection of the indicator.

Prior to the use of the apparatus and the calibration step just described, each of the resistors 50, 52 and 54 have been adjusted to ensure that appropriate deflection of the indicator 66 will be obtained when the apparatus is used. Assume now that the test to be conducted is one wherein the current drain is expected to be less than 10 amps. The contact 55 of the switching

means 49 is closed to connect the resistor 54 in circuit with the output of the amplifier 18 because the calibrate switch 48 has been released. The movable contact 58 is now closed with the stationary contact 56. The particular load or circuit element to be tested could, for instance, be the headlights of a vehicle. Those lights can now be turned on, and assuming the circuit is operating properly, there will be an appropriate deflection of the indicator.

To recapitulate, when the calibrate switch 48 was operated by the pushbutton 76 by manipulation of the knob 42 and consequently the value of the resistor 40 was changed, the gain of the amplifier 18 was calibrated to take into account the resistance of the vehicle grounding strap. As this resistance and the gain in the amplifier were the only variables, the indicator has been calibrated and will now read either charge or discharge currents with a high degree of accuracy.

The apparatus may now be used to measure the current drain of any electrical device on the vehicle. It may also be used to measure the output of the alternator or generator by proper operation of any one of the switches 51,53 or 55 which determine the proper range. Thus it is to be expected that when the vehicle starter motor is operated the current drain should be in excess of 50 amps. When it is desired to conduct this test the switch 51 is operated to complete a circuit to the resistor 50. Others of the switches 53 and 55 may be individually operated when measuring current drain caused by different loads.

It is also possible to measure the leakage current of the entire electrical system. This can be done by removing the ter inal or connector 10 from the negative
terminal 6 of the battery. If the pointer of the indicator 66 remains at zero there is no leakage current.
If there is a leakage current the pointer will be deflected.

Other tests may be conducted utilizing the apparatus
and method of embodiments of the invention.

Claims:

1.     A method of testing electrical systems having a
number of different circuits, each with its own load
and a conductive element (8) having an unknown resistance common to all through which current in the system
flows when any one or more of the loads is energized;
comprising: the step of connecting a current measuring
circuit (14,20,18,38,66) including an indicator (66) to
the common conductive element (8), the step of passing
a known current through the common conductive element
(8) and at the same time calibrating the indicator (66)
to eliminate the effect of different resistances which
may exist in the common conductive element (8), and
then energizing any one or more of the loads in the
different circuits of the electrical system and measuring the current through the common conductive element
(8) caused by the energized load or loads.

2.     A method according to Claim 1, wherein the
second step is effected in part by regulating the
current flow in the common conductive element (8).

3.     A method according to Claim 2, wherein the
second step is effected in part by adjusting the gain
(40,42) of the current measuring circuit.

4.     A method according to any one of Claims 1,2 or 3,
including the step of selecting an operating range
(51,53,55) for the indicator (66).

5.     A method according to any one of Claims 1 to 4,
wherein said electrical system includes a battery source
(2) and said conductive element (8) is connected between
the battery terminal (6) and the ground (9) whereby when any one or more of the loads is energized current will flow in the ground conductor (8), and wherein said current measuring circuit (14,20,18,38,66) is connected to said ground conductor (8).

6. A method according to Claims 2 and 5, wherein the second step is effected in part by connecting a current regulating circuit (80,82) to ground (9) and to the ungrounded terminal (4) of the battery (2).

7. Apparatus for testing electrical systems having a number of different circuits, each with its own load and a conductor (8) connected between a terminal (6) of a source (2) and common ground (9) whereby when any one or more of the loads is energized current will flow in the conductor (8) comprising a current measuring circuit (14,20,18,38,66) including an indicator (66) and variable gain amplifying means (18) having two inputs (14,20) and having its output (38) connected to said indicator (66), means for connecting (10,12) the inputs of said amplifying means (14,20) across the ground conductor (8), means for drawing (80,82) a known current through the ground conductor (8) and means for selectively (76) connecting said last mentioned means (80,82) to said current measuring circuit (14,20,18, 38,66).

8. Apparatus as claimed in Claim 7, wherein said amplifier (18) is a differential amplifier.

9. Apparatus as claimed in either Claim 7 or Claim 8, wherein range selection means (49) are provided between the output (38) of said amplifier (18) and said indicator(66).

10.     Apparatus as claimed in Claim 9, wherein means (76) are provided for selectively connecting said range selection means (49) to said source terminal (4), said selectively connecting means (76) comprising a multiple contact switch (76,58,74).

11.     Apparatus as claimed in any one of Claims 7 to 10, wherein said means for drawing (80,82) a known current through the ground conductor (8) comprises a current regulator (80,82) and means for connecting (86,88) said current regulator (80,82) to ground (88) and a terminal (4) of the source (2).

12.     Apparatus as claimed in Claim 11, wherein said current regulator (80,82) comprises a voltage regulator (80), a transistor means (82) connecting the control electrode(98) of said voltage regulator (80) to said transistor (82) to control the conduction thereof, and means (86) for connecting the control electrode (98) of said transistor (82) to said source terminal (4), means for connecting (96) the output of said transistor (82) to one end of a fixed resistor (84) and means (86) for connecting the other end of said fixed resistor (84) to ground (9).

0011359

FIG.I

| Category | Citation of document with indication, where appropriate, of relevant passages | Relevant to claim |
|---|---|---|
| | DE – A – 2 004 972 (VOLKSWAGENWERK) <br> * complete document * <br> -- | 1,5,7 |
| | GB – A – 1 330 412 (MARCONI COMPANY) <br> * complete document * <br> -- | 1,7,8 |
| A | DE – A1 – 2 657 046 (SUN ELECTRIC) <br> * claim 38; page 47, line 8 to line 25; fig. 1, 25 part 1 * <br> -- | |
| A | DE – C – 860 667 (GENERAL MOTORS) <br> * page 1, line 1 to page 2, line 32 * <br> -- | |
| A | US – A – 3 594 642 (W.B. WRIGHT) <br> * column 1, line 13 to column 2, line 60 * <br> ---- | |

### DOCUMENTS CONSIDERED TO BE RELEVANT

**CLASSIFICATION OF THE APPLICATION (int. Cl.)**

G 01 R 19/00
G 01 R 31/00
B 60 R 16/00

**TECHNICAL FIELDS SEARCHED (Int.Cl.)**

B 60 Q 9/00
B 60 R 16/00
G 01 R 19/00
G 01 R 19/145
G 01 R 31/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 18-02-1980 | LEMMERICH |

EPO Form 1503.1 06.78